# EUROPEAN PATENT SPECIFICATION

(11) **EP 2 133 860 B1**
(45) Date of publication and mention of the grant of the patent: **12.10.2016**
(21) Application number: 09162361.1
(22) Date of filing: 10.06.2009
(51) Int. Cl.: G09G 3/32

(54) **Organic light emitting display and driving method thereof**
Organische lichtemittierende Anzeige und Verfahren zu ihrer Ansteuerung
Affichage électroluminescent organique et procédé de commande correspondant

(30) Priority: 11.06.2008 US 60749 P; 07.04.2009 US 419875
(43) Date of publication of application: 16.12.2009
(73) Proprietor: Samsung Display Co., Ltd., Gyeonggi-do (KR)
(72) Inventor: Kim, Yang-Wan, Gyunggi-do (KR)
(74) Representative: Gulde & Partner

(56) References cited:
- EP-A1- 1 381 019
- WO-A1-2005/109389
- US-A1- 2003 071 821
- US-A1- 2006 145 965
- US-A1- 2008 036 708

## Description

### BACKGROUND

### 1. Field of the Invention

The present invention relates to an organic light emitting display and a driving method thereof.

### 2. Discussion of Related Art

Recently, various flat panel display devices having reduced weight and volume in comparison to cathode ray tubes (CRTs) have been developed. Types of flat panel display devices include a liquid crystal display (LCD), a field emission display (FED), a plasma display panel (PDP), and an organic light emitting display, etc.

An organic light emitting display displays an image using organic light emitting diodes that generate light through recombination of electrons and holes. The organic light emitting display has an advantage over other flat panel display devices in that it has a high response speed and is driven with low power consumption.

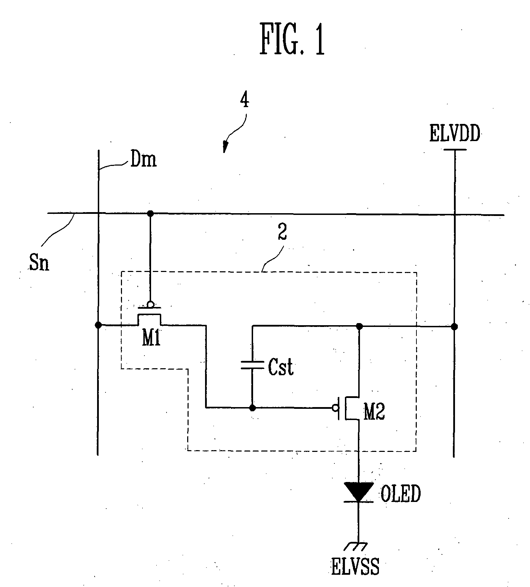

FIG. 1 is a circuit view showing a pixel of a conventional organic light emitting display.

Referring to FIG. 1, a pixel 4 of a conventional light emitting display includes an organic light emitting diode (OLED) and a pixel circuit 2 coupled to a data line Dm and a scan line Sn to control the organic light emitting diode (OLED).

An anode electrode of the organic light emitting diode (OLED) is coupled to the pixel circuit 2 and a cathode electrode of the OLED is coupled to a second power supply ELVSS. The pixel circuit 2 controls an amount of current supplied to the OLED in accordance with a data signal supplied to the data line Dm when a scan signal is supplied to the scan line Sn. To this end, the pixel circuit 2 includes a second transistor M2 coupled between a first power supply ELVDD and the OLED, a first transistor M1 coupled between the second transistor M2, the data line Dm, and the scan line Sn, and a storage capacitor Cst coupled between a gate electrode and a first electrode of the second transistor M2.

A gate electrode of the first transistor M1 is coupled to the scan line Sn and a first electrode of the first transistor M1 is coupled to the data line Dm. Further, a second electrode of the first transistor M1 is coupled to one terminal of the storage capacitor Cst. Here, the first electrode may be either a source electrode or a drain electrode and the second electrode may be the other one of the source electrode or the drain electrode. For example, if the first electrode is the source electrode, the second electrode is the drain electrode. The first transistor M1 is turned on when the scan signal is applied at its gate to supply the data signal supplied from the data line Dm to the storage capacitor Cst. At this time, the storage capacitor Cst charges a voltage corresponding to the data signal.

The gate electrode of the second transistor M2 is coupled to one side of the storage capacitor Cst and the first electrode of the second transistor M2 is coupled to the other side of the storage capacitor Cst and the first power supply ELVDD. Further, a second electrode of the second transistor M2 is coupled to the anode electrode of the OLED. The second transistor M2 controls the amount of current flowing from the first power supply ELVDD to the second power supply ELVSS via the OLED in accordance with the voltage value stored in the storage capacitor Cst. At this time, the OLED generates light corresponding to the amount of current supplied from the second transistor M2.

The conventional organic light emitting display may not display an image with desired luminance due to the change in efficiency according to the deterioration of the OLED. In practice, the OLED is deteriorated over time so that light with gradually low luminance is generated in response to the same data signal supplied through the data line Dm.

WO 2005/109389 A1 discloses correcting data for individual pixels on the basis of characteristic curves of current control means and light emitting means of an element of a light emitting display. Further related art is disclosed in US 2006/145965 A1, US 2008/036708 A1, US 2003/071821 A1 and EP 1 381 019A1.

### SUMMARY OF THE INVENTION

Therefore, it is an aspect according to an exemplary embodiment of the present invention to provide an organic light emitting display and a driving method thereof capable of compensating for a deterioration of organic light emitting diodes and a non-uniform threshold voltage/mobility among driving transistors in different pixel circuits.
In an exemplary embodiment according to the present invention, an organic light emitting display according to claim 1 includes: a plurality of scan lines for applying scan signals; a plurality of control lines for applying control signals; a plurality of data lines for applying data signals, the data lines crossing the scan lines and the control lines; a plurality of pixels for displaying an image, the pixels coupled to the scan lines, the control lines and the data lines wherein each of the pixels comprises a driving transistor and an organic light emitting diode coupled in series between a corresponding one of the power supply lines and a power source, the organic light emitting diode having an anode coupled to the driving transistor and a cathode coupled to the second power source, a data switch connected between a corresponding one of the data lines and a control electrode of the driving transistor, the data switch having a control electrode coupled to a corresponding one of the scan lines; a capacitor coupled between a corresponding one of the power supply lines and the control electrode of the driving transistor and adapted to store a corresponding one of the data signals; and a control switch connected between the corresponding one of the data lines and the anode of the organic light emitting diode, the control switch having a control electrode coupled to a corresponding one of the control lines; a plurality of power supply lines coupled to the pixels; a data driver for supplying the data signals of the image to the plurality of data lines; a power supply driver for swinging a voltage at the power supply lines between a first level and a second level; a sensing unit including a current sink configured to sink a first current from the pixels and a current source configured to supply a second current to the pixels; and a switching unit for selectively electrically coupling the plurality of pixels to at least one of the data driver, the current source or the current sink. The sensing unit further comprises a current source configured to supply a second current to the pixels during the second testing period wherein the sensing unit is adapted to sink a first current during the first testing period and to sink a second current during the second testing period and is further adapted to sense a first voltage during the first testing period and to sense a second voltage during the second testing period and in that the data driver is adapted to convert external image data to a data signal to be applied to the pixels in accordance with the first voltage and the second voltage.

The power supply driver is further adapted to supply the power supply voltage during the first testing period having a level higher than during the second testing period.

Each of the pixels may include: a driving transistor and an organic light emitting diode coupled in series between a corresponding one of the power supply lines and a power source, the organic light emitting diode having an anode coupled to the driving transistor and a cathode coupled to the second power source; a data switch between a corresponding one of the data lines and a control electrode of the driving transistor, the data switch having a control electrode coupled to a corresponding one of the scan lines; a capacitor coupled between the first power source and the control electrode of the driving transistor for storing a corresponding one of the data signals; and a control switch between the corresponding one of the data lines and the anode of the organic light emitting diode, the control switch having a control electrode coupled to a corresponding one of the control lines.

The switching unit may include: a first switch between the corresponding one of the data lines and the data driver, the first switch being adapted to turn on when the data driver supplies the corresponding one of the data signals to the corresponding one of the data lines; a second switch between the corresponding one of the data lines and the current source, the second switch being adapted to turn on when the current source supplies the first current to the corresponding one of the data lines; and a third switch between the corresponding one of the data lines and the current sink, the third switch being adapted to turn on when the current sink receives the second current from the corresponding one of the data lines.

The organic light emitting display may further include a memory for storing the first voltage and the second voltage.

The organic light emitting display may further include a timing controller adapted to receive external data signals, wherein the timing controller is configured to convert the external data signals to the data signals in accordance with the first voltage and the second voltage.

The first voltage may correspond to threshold voltage/mobility information of the driving transistor. The second voltage may correspond to deterioration information of the organic light emitting diode.

The sensing unit may further include an analog-to-digital converter for converting the first voltage and the second voltage to digital data prior to storing them in the memory.

In another exemplary embodiment according to the present invention, a method according to claim 8 of adjusting luminance of an image displayed on an organic light emitting display is provided. The organic light emitting display includes a plurality of pixels coupled to a plurality of data lines, each of the pixels including a driving transistor and an organic light emitting diode coupled in series between a corresponding one of the power supply lines and a power source, the organic light emitting diode having an anode coupled to the driving transistor and a cathode coupled to the second power source, a data switch connected between a corresponding one of the data lines and a control electrode of the driving transistor, the data switch having a control electrode coupled to a corresponding one of the scan lines; a capacitor coupled between a corresponding one of the power supply lines and the control electrode of the driving transistor and adapted to store a corresponding one of the data signals; and a control switch connected between the corresponding one of the data lines and the anode of the organic light emitting diode, the control switch having a control electrode coupled to a corresponding one of the control lines. The method includes: sensing a first voltage while a first current flows through the driving transistor of a pixel among the plurality of pixels to a current sink via a corresponding one of the data lines while a first voltage is being supplied to a corresponding one of the pixels; sensing a second voltage while a second current flows from a current source through the organic light emitting diode of the pixel via the corresponding one of the data lines while a second voltage that is lower than the first voltage is being supplied to the corresponding one of the pixels; and converting external data to a data signal to be applied to the pixel in accordance with the first voltage and the second voltage.

In another exemplary embodiment according to the present invention, an organic light emitting display includes: a plurality of pixels coupled to a plurality of data lines, each of the pixels including a driving transistor and an organic light emitting diode; a current sink for sensing a first voltage corresponding to a first current that flows through the driving transistor of a pixel among the plurality of pixels to the current sink via a corresponding one of the data lines; a current source for sensing a second voltage corresponding to a second current that flows from the current source through the organic light emitting diode of the pixel via the corresponding one of the data lines; a timing controller for adjusting a data signal to be applied to the pixel in accordance with the first voltage and the second voltage; and a power supply line driver for supplying power to the pixels, wherein the power supplied while the first voltage is being sensed has a higher voltage than that of the power supplied while the second voltage is being sensed.

### BRIEF DESCRIPTION OF THE DRAWINGS

The accompanying drawings, together with the specification, illustrate exemplary embodiments of the present invention, and, together with the description, serve to explain the principles of the present invention.
FIG. 1 is a view showing a pixel of a conventional organic light emitting display;
FIG. 2 is a view showing an organic light emitting display according to an exemplary embodiment of the present invention;
FIG. 3 is a view showing an embodiment of a pixel shown in FIG. 2;
FIG. 4 is a view showing in detail a switching unit, a sensing unit, and a control block shown in FIG. 2;
FIG. 5 is a view showing a sensing circuit shown in FIG. 4;
FIG. 6 is a view showing a data driver shown in FIG. 2;
FIGS. 7A, 7B and 7C are views showing a driving waveform supplied to a pixel and a switching unit in an exemplary embodiment according to the present invention; and
FIGS. 8A, 8B and 8C are views that show a data driver, a timing controller, a control block, a sensing unit, a switching unit, and a pixel, and a current flow corresponding to the waveforms of FIGS. 7A, 7B and 7C, respectively.

### DETAILED DESCRIPTION OF EXEMPLARY EMBODIMENTS

Hereinafter, certain exemplary embodiments according to the present invention will be described with reference to the accompanying drawings. Here, when a first element is described as being coupled to a second element, the first element may be directly coupled to the second element, or may be indirectly coupled to the second element via a third element. Further, some of the elements that are not essential to the complete understanding of the invention are omitted for clarity. Also, like reference numerals refer to like elements throughout.

Hereinafter, embodiments of the present invention will be described in detail with reference to the accompanying drawings.

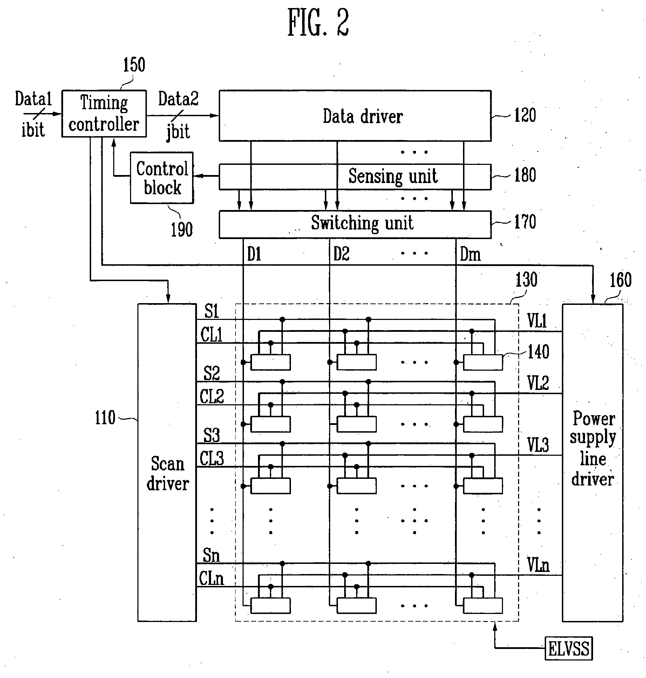

FIG. 2 is a view showing an organic light emitting display according to an exemplary embodiment of the present invention.

Referring to FIG. 2, the organic light emitting display according to an exemplary embodiment of the present invention includes a display unit 130 having pixels positioned at crossing regions of scan lines S1 to Sn and data lines D1 to Dm; a scan driver 110 for driving scan lines S1 to Sn and control lines CL1 to CLn; a power supply line driver 160 for driving power supply lines VL1 to VLn; a data driver 120 for driving data lines D1 to Dm; and a timing controller 150 for controlling the scan driver 110, the data driver 120 and the power supply line driver 160.

The organic light emitting display also includes a sensing unit 180 for extracting deterioration information of an organic light emitting diode included in each pixel 140 and threshold voltage/mobility information of a driving transistor; a switching unit 170 for selectively coupling the sensing unit 180 and the data driver 120 to the data lines D1 to Dm; and a control block 190 for storing information sensed by the sensing unit 180.

The display unit 130 includes the pixels 140 positioned at the crossing regions of the scan lines S1 to Sn and the data lines D1 to Dm. The pixels 140 are supplied with first power ELVDD through the power supply lines VL and are supplied with second power ELVSS from the outside. Each of the pixels 140 supplied with the first power ELVDD and the second power ELVSS controls the amount of current supplied from the first power ELVDD to the second power ELVSS via the organic light emitting diode. Then, light with luminance corresponding to the current is generated in the organic light emitting diode.

The scan driver 110 drives the scan lines S1 to Sn and the control lines CL1 to CLn in accordance with the control by the timing controller 150. Also, the data driver 120 supplies data signals to the data lines D1 to Dm in accordance with the control by the timing controller 150. The data signals may have values ranging from +8V to +13V in one embodiment, for example.

The switching unit 170 selectively couples the sensing unit 180 and the data driver 120 to the data lines D1 to Dm. To this end, the switching unit 170 includes at least one switching device coupled (to each of the data lines D1 to Dm. In other words, at least one switching device is provided per channel (or data line) to selectively couple the sensing unit 180 or the data driver 120 to the data line.

The sensing unit 180 extracts the deterioration information of the organic light emitting diode included in each pixel 140 and supplies the extracted deterioration information to the control block 190. Also, the sensing unit 180 extracts the threshold/mobility information of the driving transistor included in each pixel 140 and supplies the extracted threshold voltage/mobility information to the control block 190. To this end, the sensing unit 180 includes the sensing circuit coupled to each of the data lines D1 to Dm. In other words, the sensing unit 180 may have a sensing circuit per channel (e.g., per data line).

The control block 190 stores the deterioration information and the threshold voltage/mobility information supplied from the sensing unit 180. In one embodiment, the control block 190 stores the deterioration information of the organic light emitting diode and the threshold voltage/mobility information of the driving transistor included in each of the pixels. To this end, the control block 190 in one embodiment includes a memory and a controller for transferring the information stored in the memory to the timing controller 150.

The timing controller 150 controls the data driver 120, the scan driver 110, and the control line driver 160. Also, the timing controller 150 generates second data Data2 by converting bit value of first data Data1 input from the outside, in accordance with the information supplied from the control block 190. In one embodiment, the number of bits in the first data Data1 is i (i is a natural number) and the number of bits in the second data Data2 is j (j is a natural number having a value of i or more). In one embodiment, i = 8; in other embodiments, i may be 6, 8 or 10. In one embodiment, j = 8 or 10; in other embodiments, j may be 6, 8, 10 or 12.

The second data Data2 generated by the timing controller 150 is supplied to the data driver 120. Then, the data driver 120 uses the second data Data2 to generate the data signal and supplies the generated data signal to the pixels 140.

The power supply line driver 160 supplies voltage of a high-level first power ELVDD or a low-level first power ELVDD to the power supply lines VL1 to VLn. Although the power supply line driver 160 is coupled to the power supply lines VL1 to VLn positioned in parallel with the scan lines S1 to Sn in FIG. 2, the present invention is not limited thereto. For example, the power supply lines VL1 to VLn may be coupled to the power supply line driver 160 and be in parallel with the data lines D1 to Dm.

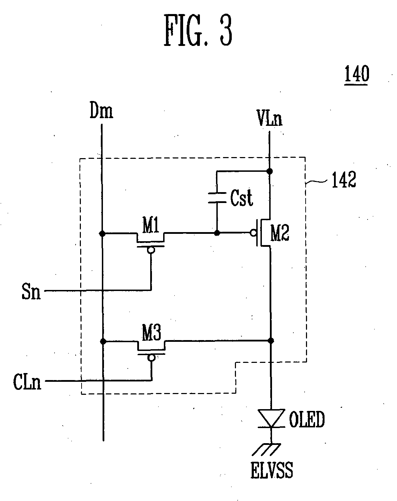

FIG. 3 is a view showing an embodiment of a pixel 140 shown in FIG. 2. For convenience of description, FIG. 3 shows a single pixel coupled to an m^{th} data lines Dm and an n^{th} scan line Sn.

Referring to FIG. 3, the pixel 140 according to one embodiment of the present invention includes an OLED and a pixel circuit 142 for supplying current to the OLED.

The anode electrode of the OLED is coupled to the pixel circuit 142 and the cathode electrode of the OLED is coupled to the second power supply ELVSS. The OLED generates light having luminance corresponding to current supplied by the pixel circuit 142.

The pixel circuit 142 is supplied with the data signal from the data line Dm when the scan signal is supplied to the scan line Sn. Also, the pixel circuit 142 provides at least one of the deterioration information of the organic light emitting diode OLED or the threshold voltage/mobility information of the driving transistor (i.e., the second transistor M2) when the control signal is supplied to the control line CLn. To this end, the pixel circuit 142 includes three transistors M1, M2 and M3 and a storage capacitor Cst.

Agate electrode of the first transistor M1 is coupled to the scan line Sn and a first electrode of the first transistor M11 is coupled to the data line Dm. Further, a second electrode of the first transistor M1 is coupled to a first terminal of the storage capacitor Cst. The first transistor M1 is turned on when the scan signal is supplied to the scan line Sn. Here, the scan signal is supplied in a period (e.g., a first period) where the threshold voltage/mobility information is sensed and in a period (e.g., a third period) where the data signal is supplied to the storage capacitor Cst.

A gate electrode of the second transistor M2 is coupled to the first terminal of the storage capacitor Cst and a first electrode of the second transistor M2 is coupled to the second terminal of the storage capacitor Cst and the power supply line VLn. The second transistor M2 controls the amount of current that flows from the high-level first power supply ELVDD to the second power supply ELVSS via the organic light emitting diode OLED in accordance with the value of the voltage stored in the storage capacitor Cst. The OLED generates light corresponding to the amount of current supplied from the second transistor M2.

A gate electrode of the third transistor M3 is coupled to the control line CLn and a first electrode of the third transistor M3 is coupled to a second electrode of the second transistor M2. Also, a second electrode of the third transistor M3 is coupled to the data line Dm. The third transistor M3 is turned on when the control signal is supplied to the control line CLn (i.e., when a low level control signal is applied at its gate). When the control signal is not supplied, the third transistor M3 is turned off. Here, the control signal is supplied during a period (e.g., a second period) in which the deterioration information of the organic light emitting diode OLED is sensed and a period (e.g., the first period) in which the threshold voltage/mobility information of the second transistor M2 is sensed.

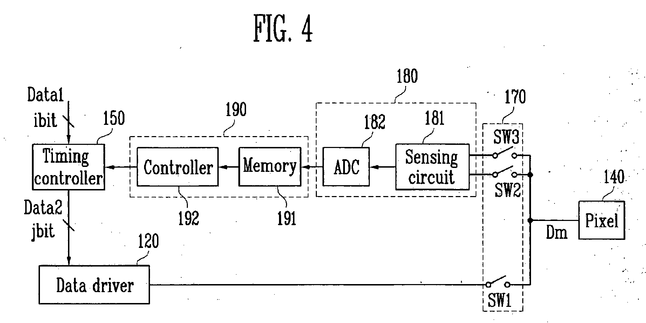

FIG. 4 further illustrates the switching unit 170, the sensing unit 180, and the control block 190 shown in FIG. 2. For convenience of description, FIG. 4 shows a connection configuration of the switching unit 170, the sensing unit 180, and the control block 190 with the m^{th} data line Dm and one of the pixels 140 coupled to the m^{th} data line Dm.

Referring to FIG. 4, three switching devices SW1, SW2 and SW3 are provided in each channel of the switching unit 170. Further, each channel of the sensing unit 180 includes a sensing circuit 181 and an analog-digital converter (hereinafter, referred to as "ADC") 182. In this and other embodiments, each ADC may be shared by a plurality of channels or a single ADC may be shared by all of the channels. Also, the control block 190 includes a memory 191 and a controller 192. The number of bits of sensed data generated by ADC may be 8 in one embodiment.

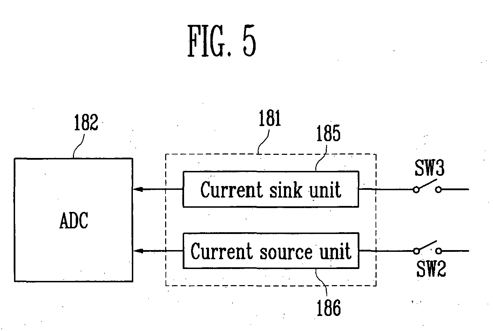

The first switching device SW1 is positioned between the data driver 120 and the data line Dm. The first switching device SW1 is turned on when the data signal is supplied from the data driver 120. In other words, the first switching device SW1 maintains the turn-on state at least during a period (e.g., the third period) in which the data signal is provided to the pixel 140 (or while the organic light emitting display displays an image). The sensing circuit 181 includes a current sink 185 and a current source 186 as shown in FIG. 5.

The current sink 185 sinks a first current from the pixel 140 when the high-level first power supply ELVDD is supplied to the power supply line VLn and supplies a corresponding voltage generated in the data line Dm to the ADC 182 when the first current is sunk. Here, the first current is sunk via the second transistor M2 included in the pixel 140. Therefore, the voltage (i.e., a first voltage) of the data line Dm generated by the current sink 185 has the threshold voltage/mobility information of the second transistor M2. The first voltage may have a value of between 5V and 8V, for example. The current value of the first current may be set variously to apply a reference voltage (e.g., a predetermined voltage) within a defined time (e.g., 4µs). For example, the first current may be set to the value of a current (e.g., 1 µA) to be flowed to the OLED when the pixel 140 is light-emitted at maximum luminance.

The current source 186 supplies a second current to the pixel 140 when the low-level first power supply ELVDD is supplied to the power supply line VLn and supplies a second voltage generated across the OLED to the ADC 182 when the second current is supplied. The second voltage may be between 8V and 10V, for example. Here, since the second current is supplied via the OLED, the second voltage has the deterioration information of the OLED.

In more detail, as the OLED is deteriorated, the resistance value of the OLED is changed (e.g., increased). Therefore, the voltage value of the second voltage is changed corresponding to the deterioration of the OLED so that the deterioration information of the OLED can be extracted. In the described embodiment, the current value of the second current is experimentally determined to be able to apply a predetermined voltage prior to the deterioration. For example, in one exemplary embodiment, the second current may be set to have the same current value as the first current.

The ADC 182 converts the first voltage supplied from the sensing circuit 181 to a first digital value and converts the second voltage to a second digital value.

The memory 191 of the control block 190 stores the first digital value and the second digital value supplied from the ADC 182. In practice, the memory 191 stores the threshold voltage/mobility information of the second transistor M2 and the deterioration information of the OLED of each of the pixels 140 included in the display unit 130.

The controller 192 transfers the first digital value and the second digital value stored in the memory 191 to the timing controller 150. Here, the controller 192 transfers to the timing controller 150 the first digital value and the second digital value extracted from the pixel 140 that will receive the second data Data2 corresponding to the first data Data1 input to the timing controller 150.

The timing controller 150 is supplied with the first data Data1 from the outside and the first digital value and the second digital value from the controller 192. The timing controller 150 supplied with the first digital value and the second digital value changes the bit value of the first data Data1 to the second data Data2 so that the image with uniform luminance can be displayed. In other words, in one embodiment, the timing controller 150 converts the first data Data1 to the second data Data2 using the first and second digital values such that the first data Data1 having the same value will result in substantially the same luminance in each of the same color pixels 140 regardless of the variation in the threshold voltage/mobility and over time regardless of the OLED deterioration.

For example, in one embodiment, the timing controller 150 decreases the bit value of the first data Data1 as the OLED is deteriorated based on the second digital value to generate the second data Data2. Then, the second data Data2 is generated reflecting the deterioration information of the OLED and thus, the generation of light with low luminance resulting from the OLED deterioration is prevented. Also, the timing controller 150 generates the second data Data2 to compensate for the threshold voltage/mobility of the second transistor M2 based on the first digital value so that the image with substantially uniform luminance can be displayed regardless of the threshold voltage/mobility of the second transistor M2.

The data driver 120 generates the data signal using the second data Data2 and supplies the generated data signal to the pixel 140.

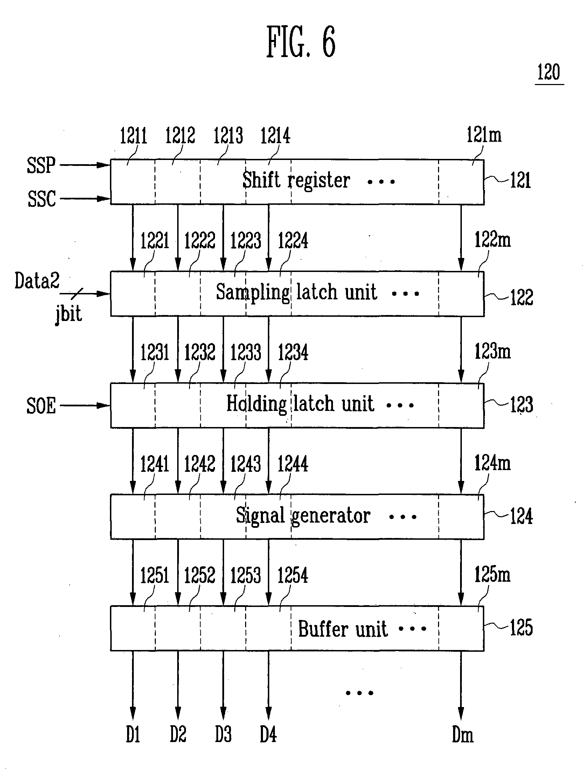

FIG. 6 is a view showing the data driver 120 according to one exemplary embodiment.

Referring to FIG. 6, the data driver 120 includes a shift register unit 121, a sampling latch unit 122, a holding latch unit 123, a signal generator 124, and a buffer unit 125.

The shift register unit 121 receives a source start pulse SSP and a source shift clock SSC from the timing controller 150. The shift register unit 121 then shifts the source start pulse SSP per one period of the source shift clock SSC to sequentially generate m sampling signals. To this end, the shift register unit 121 includes m shift registers 1211 to 121m.

The sampling latch unit 122 sequentially stores second data Data2 in response to the sampling signals sequentially supplied from the shift register unit 121. To this end, the sampling latch unit 122 includes m sampling latches 1221 to 121 m in order to store m second data Data2.

The holding latch unit 123 receives a source output enable signal SOE from the timing controller 150. The holding latch unit 123 then receives and stores second data Data2 from the sampling latch unit 122. Further, the holding latch unit 123 supplies the second data Data2 stored therein to the signal generator 124. To this end, the holding latch unit 123 includes m holding latches 1231 to 123m.

The signal generator 124 receives the second data Data2 from the holding latch unit 123 and generates m data signals corresponding to the received second data Data2. To this end, the signal generator 124 includes m digital-analog converters (hereinafter, referred to as "DAC") 1241 to 124m. That is, the signal generator 124 generates the m data signals using the DACs 1241 to 124m each positioned at a corresponding channel and supplies the generated data signals to the buffer unit 125.

The buffer unit 125 supplies the m data signals supplied from the signal generator 124 to each of m data lines D1 to Dm. To this end, the buffer unit 125 includes m buffers 1251 to 125m.

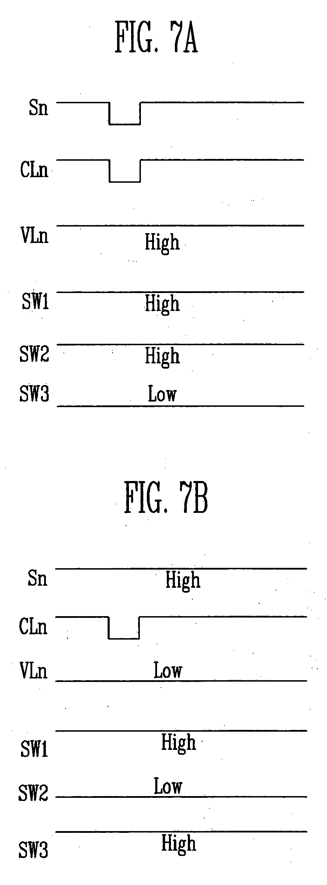

FIGS. 7A to 7C are views showing driving waveforms supplied to a pixel and a switching unit.

FIG. 7A shows a waveform diagram during the first period for sensing threshold voltage/mobility of the second transistor M2 included in the pixels 140. The scan driver 110 sequentially supplies the scan signals to the scan line S1 to Sn during a sensing period of the threshold voltage/mobility of the second transistor M2 included in the pixels 140. For example, the scan signals may have a high voltage of +14V and a low voltage of -2V in one embodiment. Also, when the scan signal is supplied to k^{th} (k is a natural number) scan line Sk, the scan driver 110 supplies a control signal to a k^{th} control line CLk. For example, the control signals may have a high voltage of +14V and a low voltage of -2V in one embodiment.

The power supply line driver 160 supplies the voltage of the high-level first power supply ELVDD to the power supply lines VL1 to VL. Here, the voltage value (e.g., 12V) of the high-level first power supply ELVDD is set to a value higher than the voltage value (e.g., 0V) of the second power supply ELVSS so that current may flow in the second transistor M2. Meanwhile, the third switching device SW3 maintains a turn-on state during the sensing period of the threshold voltage/mobility of the second transistor M2.

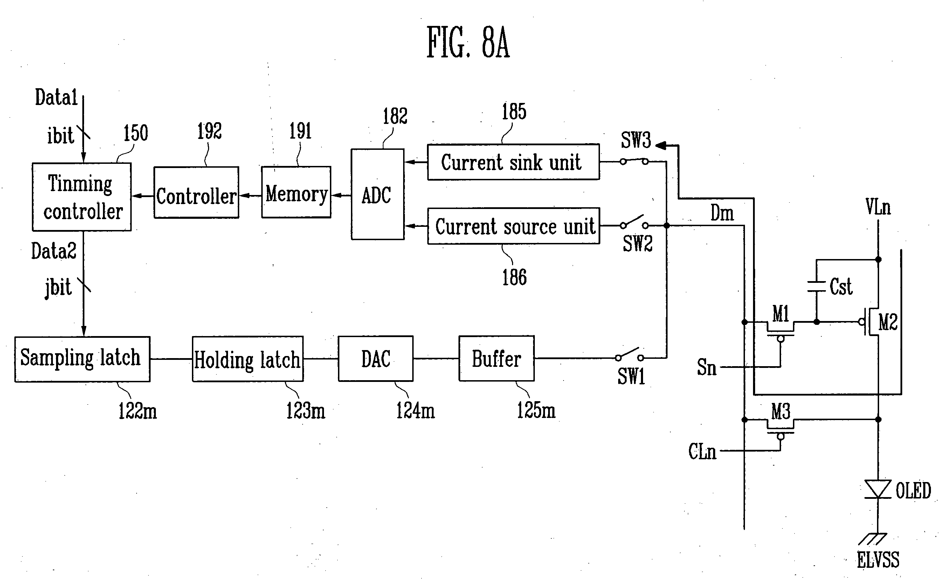

An operation process will be described in detail with reference to FIGS. 7A and 8A. First, when the scan signal is supplied to the scan line Sn, the first transistor M1 is turned on. When the first transistor M1 is turned on, the gate electrode of the second transistor M2 and the data line Dm are electrically coupled. And, the third transistor M3 is turned on by the control signal supplied to the control line CLn in synchronization with the scan signal.

At this time, the current sink 185 sinks the first current (shown in FIG. 8A) from the first power supply ELVDD via the second transistor M2, the third transistor M3, and the third switching device SW 3. When the first current is sunk in the first sink unit 185, the first voltage is applied to the current sink 185. Here, since the first current is sunk via the second transistor M2, information on the threshold voltage/mobility of the second transistor M2 is included in the first voltage. For example, in one embodiment, the voltage applied to the gate electrode of the second transistor M2 is used as the first voltage.

The first voltage applied to the current sink 185 is converted to a first digital value in the ADC 182 to be supplied to the memory 191. Accordingly, the first digital value is stored in the memory 191. Through such a process, the first digital value including the information on the threshold voltage/mobility of the second transistor M2 included in each of the pixels 140 is stored in the memory 191.

In the described embodiment of the present invention, a process for sensing the threshold voltage/mobility of the second transistor M2 may be performed more than once before the organic light emitting display is used. For example, before the organic light emitting display is shipped, it is possible to sense the threshold voltage/mobility of the second transistor M2 to store it in the memory 191. Also, the process for sensing the threshold voltage/mobility of the second transistor M2 may be performed at the time of user's designation.

FIG. 7B shows a waveform diagram during the second period for sensing deterioration information of the organic light emitting diode included in each of the pixels.

The scan driver 110 sequentially supplies the control signals to the control lines CL1 to CLn during a sensing period of the deterioration information of the organic light emitting diode OLED included in each of the pixels 140. The second switching device SW2 maintains a turn-on state during the sensing period of the deterioration information of the organic light emitting diode OLED. Also, the power supply line driver 160 supplies the low-level first power ELVDD to the power supply lines VL1 to VLn during the sensing period of the deterioration information of the organic light emitting diode OLED. Here, the low-level first power ELVDD is set to a voltage capable of turning off the second transistor M2. For example, the low level first power ELVDD may be set to the same voltage as the second power ELVSS.

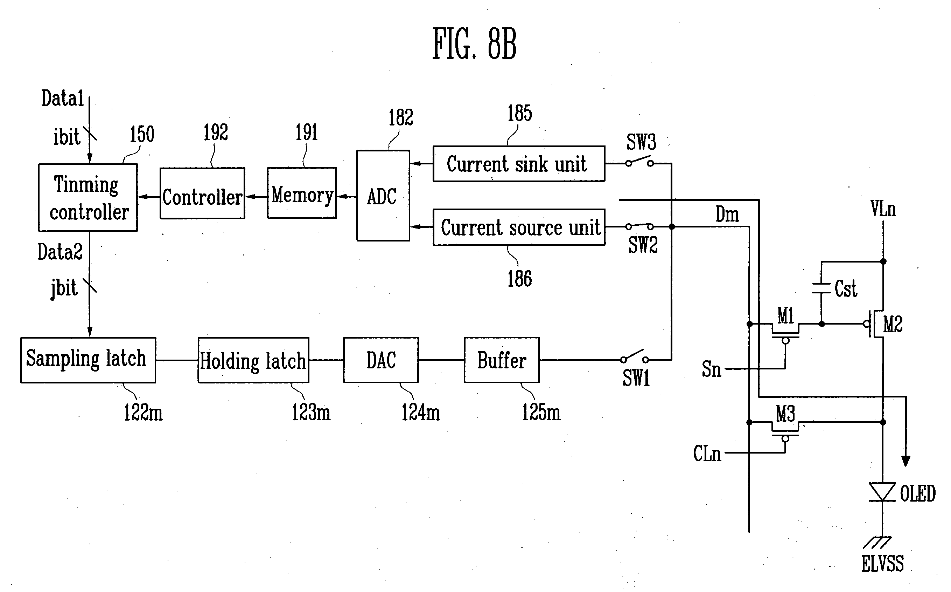

An operation process will be described in detail with reference to FIGS. 7B and 8B. First, when the control signal is supplied to the control line CLn, the third transistor M3 is turned on. When the third transistor M3 is turned on, the organic light emitting diode OLED and the data line Dm are electrically coupled to each other.

In this case, the second current supplied by the current source 186 is supplied to the organic light emitting diode OLED via the second switching device SW2 and the third transistor M3. At this time, when the second current is supplied, the current source 186 senses the second voltage applied to the organic light emitting diode OLED and supplies the sensed second voltage to the ADC 182.

The ADC 182 converts the second voltage supplied from the current source 186 to a second digital value to supply it to the memory 191. Accordingly, the second digital value is stored in the memory 191. Through such a process, the second digital value including deterioration information of the organic light emitting diode OLED included in each of the pixels 140 is stored in the memory 191.

In the described embodiment of the present invention, the process for sensing the organic light emitting diode OLED may be performed at a time predefined by a designer. For example, the deterioration information of the organic light emitting diode OLED may be sensed whenever power is supplied to the organic light emitting display.

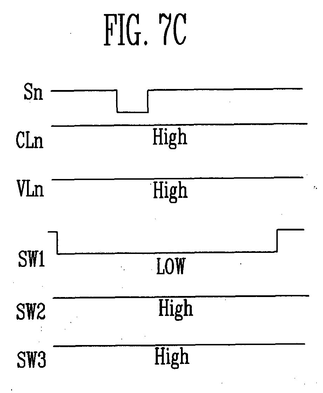

FIG. 7C shows a waveform diagram for the third period for performing a normal display operation.

During the normal display operation period, the scan driver 110 sequentially supplies the scan signals to the scan lines S1 to Sn, and does not supply the control signals to the control lines CL1 to CLn. During the normal display operation period, the power line driver 160 supplies the high-level first power ELVDD to the power supply lines VL1 to VLn. Further, during the normal display operation period, the first switching device SW1 maintains the turn-on state.

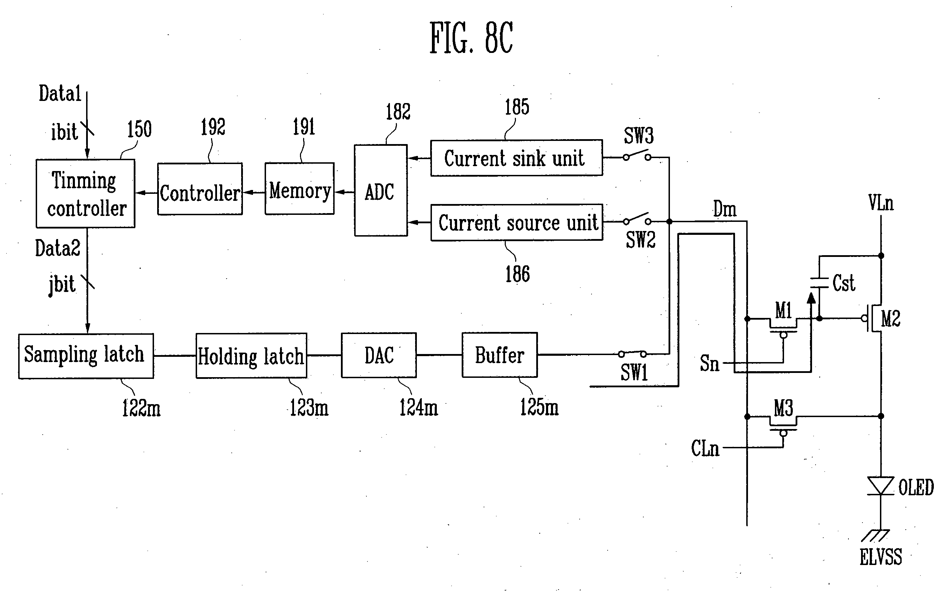

An operation process will be described in detail with reference to FIGS. 7C and 8C. First, the first data Data1 to be supplied to the pixel 140 coupled to the data line Dm and the scan line Sn is supplied to the timing controller 150. At this time, the controller 192 supplies the first digital value and the second digital value extracted from the pixel 140 coupled to the data line Dm and the scan line Sn to the timing controller 150.

After receiving the first and second digital values, the timing controller 150 modifies a bit value of the first data Data1 to generate the second data Data2. Here, the second data Data2 is set so that the deterioration of the organic light emitting diode OLED and the threshold voltage/mobility of the second transistor M2 may be compensated for.

For example, when the first data of "00001110" is input, the timing controller 150 can generate the second data Data2 of "000011110" so that the deterioration of the organic light emitting diode OLED may be compensated for. In this case, since the data signal for displaying the image of a high luminance is generated corresponding to the second data Data2, the deterioration of the organic light emitting diode OLED may be compensated for. Likewise, the timing controller 150 controls the bit value of the second data Data2 so that the deviation in the threshold voltage/mobility of the second transistor may be compensated for.

The second data Data2 generated by the timing controller 150 is supplied to the DAC 124m via the sampling latch 122m and the hold latch 123m. In this case, the DAC 124m generates the data signal using the second data Data2 and supplies the generated data signal to the data line Dm via the buffer 125m.

Here, since the scan signal is supplied to the scan line Sn so that the first transistor M1 is turned on, the data signal supplied to the data line Dm is supplied to the gate electrode of the second transistor M2. At this time, the storage capacitor Cst is charged with the voltage corresponding to the data signal.

Thereafter, the supply of the scan signal is stopped so that the first transistor M1 is turned off. At this time, the second transistor M2 supplies the current corresponding to the voltage charged in the storage capacitor Cst to the organic light emitting diode OLED. In this case, the organic light emitting diode OLED generates light with a luminance corresponding to the amount of current supplied thereto.

Here, the current supplied to the organic light emitting diode OLED is set so that the deterioration of the organic light emitting diode OLED and the threshold voltage/mobility of the second transistor M2 may be compensated for. Therefore, it is possible to uniformly display the image with a desired luminance. In other words, in one embodiment, the same color OLED would generate substantially the same luminance corresponding to the same data Data1 regardless of the threshold voltage/mobility of the second transistor M2 and the deterioration status of the OLED.

## Claims

1. An organic light emitting display comprising:
a scan driver adapted to apply scan signals to a plurality of scan lines and to apply control signals to a plurality of control lines;
a data driver adapted to supply data signals of an image to a plurality of data lines during an operation period, the data lines crossing the scan lines and the control lines;
a plurality of pixels adapted to display the image and coupled to the scan lines, the control lines and the data lines wherein each of the pixels comprises:
a driving transistor and an organic light emitting diode coupled in series between a corresponding one of the power supply lines and a power source, the organic light emitting diode having an anode coupled to the driving transistor and a cathode coupled to the second power source;
a data switch connected between a corresponding one of the data lines and a control electrode of the driving transistor, the data switch having a control electrode coupled to a corresponding one of the scan lines;
a capacitor coupled between a corresponding one of the power supply lines and the control electrode of the driving transistor and adapted to store a corresponding one of the data signals; and
a control switch connected between the corresponding one of the data lines and the anode of the organic light emitting diode, the control switch having a control electrode coupled to a corresponding one of the control lines;
a power supply driver connected to a plurality of power supply lines and adapted to supply a power supply voltage to the pixels through the power supply lines;
a sensing unit comprising a current sink configured to sink a currents flowing through the driving transistor of one pixel among the plurality of pixels via a corresponding one of the data lines during testing periods and adapted to sense a voltages during the testing periods wherein the data driver is adapted to adjust luminance of an image by converting external image data to a data signal to be applied to the pixels in accordance with the voltages; and
a switching unit adapted to selectively electrically couple the plurality of pixels to the current sink,
**characterised in that**
the power supply voltage is selectable from a voltage range between a first level and a second level wherein the power supply driver is further adapted to supply a first power supply voltage during a first of the testing periods having a level higher than a second power supply voltage supplied during a second of the testing periods,
the switching unit is further adapted to selectively electrically couple the plurality of pixels to one of the data driver, the current source or the current sink, and
the sensing unit further comprises a current source configured to supply a second current to the pixels during the second testing period wherein the sensing unit is adapted to sink a first current during the first testing period and to sink a second current during the second testing period and to sense a first voltage during the first testing period and to sense a second voltage during the second testing period wherein the data driver is adapted to convert the external image data in accordance with the first and the second voltage .

2. The organic light emitting display of claim 1, wherein the switching unit comprises:
a first switch connected between the corresponding one of the data lines and the data driver;
a second switch connected between the corresponding one of the data lines and the current source;
a third switch connected between the corresponding one of the data lines and the current sink; and
a switch unit controller adapted to turn on the first switch during the operation period, to turn on the second switch during the second testing period, and to turn on the third switch during the first testing period.

3. The organic light emitting display of one of the preceding claims, further comprising a memory adapted to store the first voltage and the second voltage.

4. The organic light emitting display of one of the preceding claims, further comprising a timing controller adapted to receive external data signals, wherein the timing controller is configured to convert the external data signals to the data signals in accordance with the first voltage and the second voltage.

5. The organic light emitting display of one of the preceding claims, wherein the first voltage comprises threshold voltage/mobility information of the driving transistor.

6. The organic light emitting display of one of the preceding claims, wherein the second voltage comprises deterioration information of the organic light emitting diode.

7. The organic light emitting display of one of the preceding claims, wherein the sensing unit further comprises an analog-to-digital converter adapted to convert the first voltage and the second voltage to digital data.

8. A method of adjusting luminance of an image displayed on an organic light emitting display comprising:
a scan driver adapted to apply scan signals to a plurality of scan lines and to apply control signals to a plurality of control lines;
a data driver adapted to supply data signals of an image to a plurality of data lines during an operation period, the data lines crossing the scan lines and the control lines;
a plurality of pixels adapted to display the image and coupled to the scan lines, the control lines and the data lines wherein each of the pixels comprises:
a driving transistor and an organic light emitting diode coupled in series between a corresponding one of the power supply lines and a power source, the organic light emitting diode having an anode coupled to the driving transistor and a cathode coupled to the second power source;
a data switch connected between a corresponding one of the data lines and a control electrode of the driving transistor, the data switch having a control electrode coupled to a corresponding one of the scan lines;
a capacitor coupled between a corresponding one of the power supply lines and the control electrode of the driving transistor and adapted to store a corresponding one of the data signals; and
a control switch connected between the corresponding one of the data lines and the anode of the organic light emitting diode, the control switch having a control electrode coupled to a corresponding one of the control lines;
a power supply driver connected to a plurality of power supply lines and adapted to supply a power supply voltage to the pixels through the power supply lines;
a sensing unit comprising a current sink configured to sink a first current from the pixels during a first testing period and adapted to sense a first voltage during the first testing period and further adapted to sense a second voltage during a second testing period wherein the data driver is adapted to convert external image data to a data signal to be applied to the pixels in accordance with the first voltage and further adapted to convert the external image data to the data signal to be applied to the pixels in accordance with the second voltage; and
a switching unit adapted to selectively electrically couple the plurality of pixels to the current sink,
**characterised in that**
the power supply voltage is selectable from a voltage range between a first level and a second level wherein the power supply driver is further adapted to supply a first power supply voltage during the first testing period having a level higher than a second power supply voltage supplied during the second testing period,
the switching unit is further adapted to selectively electrically couple the plurality of pixels to one of the data driver, the current source or the current sink, and
the sensing unit further comprises a current source configured to supply a second current to the pixels during the second testing period, the method comprising:
sensing a first voltage while a first current flows through the driving transistor of a pixel among the plurality of pixels to a current sink via a corresponding one of the data lines while a first voltage is being supplied to a corresponding one of the pixels;
sensing a second voltage while a second current flows from a current source through the organic light emitting diode of the pixel via the corresponding one of the data lines while a second voltage that is lower than the first voltage is being supplied to the corresponding one of the pixels; and
converting external data to a data signal to be applied to the pixel in accordance with the first voltage and the second voltage.

9. The method according to claim 8, further comprising converting the first voltage and the second voltage to digital data and storing the digital data in a memory.

## Patentansprüche

1. Organische lichtemittierende Anzeige, aufweisend:
einen Ansteuertreiber, der angepasst ist, um Ansteuersignale an eine Vielzahl von Ansteuerleitungen anzulegen und Steuersignale an eine Vielzahl von Steuerleitungen anzulegen;
einen Datentreiber, der angepasst ist, um während einer Betriebsperiode Datensignale eines Bildes an eine Vielzahl von Datenleitungen anzulegen, wobei die Datenleitungen die Ansteuerleitungen und die Steuerleitungen kreuzen;
eine Vielzahl von Pixeln, die angepasst sind, um das Bild anzuzeigen, und mit den Ansteuerleitungen, den Steuerleitungen und den Datenleitungen gekoppelt sind, wobei jeder der Pixel aufweist:
einen Ansteuertransistor und eine organische lichtemittierende Diode, die zwischen eine entsprechende der Energieversorgungsleitungen und eine Energiequelle in Reihe geschaltet ist, wobei die organische lichtemittierende Diode eine Anode, die mit dem Ansteuertransistor gekoppelt ist, und eine Kathode, die mit der zweiten Energiequelle gekoppelt ist, aufweist;
einen Datenschalter, der zwischen eine entsprechende der Datenleitungen und eine Steuerelektrode des Ansteuertransistors geschaltet ist, wobei der Datenschalter eine Steuerelektrode, die mit einer entsprechenden der Ansteuerleitungen gekoppelt ist, aufweist;
einen Kondensator, der zwischen eine entsprechende der Energieversorgungsleitungen und die Steuerelektrode des Ansteuertransistors geschaltet ist, und angepasst ist, um ein entsprechendes der Datensignale zu speichern; und
einen Steuerschalter, der zwischen die entsprechende der Datenleitungen und die Anode der organischen lichtemittierenden Diode geschaltet ist, wobei der Steuerschalter eine Steuerelektrode, die mit einer entsprechenden der Steuerleitungen gekoppelt ist, aufweist;
einen Energieversorgungstreiber, der mit einer Vielzahl von Energieversorgungsleitungen verbunden ist und angepasst ist, um die Pixel über die Energieversorgungsleitungen mit einer Versorgungsspannung zu versorgen;
eine Abtasteinheit, die eine Stromsenke, die konfiguriert ist, um Ströme, die über eine entsprechende der Datenleitungen durch den Ansteuertransistor eines Pixels aus der Vielzahl der Pixel fließen, während Testperioden aufzunehmen, aufweist und angepasst ist, um Spannungen während Testperioden abzutasten, wobei der Datentreiber angepasst ist, um die Leuchtdichte eines Bildes durch Umwandeln externer Bilddaten in ein an die Pixel anzulegendes Datensignal gemäß den Spannungen einzustellen; und
eine Schalteinheit, die angepasst ist, um die Vielzahl der Pixel selektiv mit der Stromsenke elektrisch zu koppeln,
**dadurch gekennzeichnet, dass**
die Versorgungsspannung aus einem Spannungsbereich zwischen einem ersten Pegel und einem zweiten Pegel ausgewählt werden kann, wobei der Energieversorgungstreiber ferner angepasst ist, um während einer ersten der Testperioden eine erste Versorgungsspannung, die einen höheren Pegel als eine zweite Versorgungsspannung, die während einer zweiten der Testperioden geliefert wird, aufweist, zu liefern,
die Schalteinheit ferner angepasst ist, um die Vielzahl der Pixel selektiv mit einem/r des Datentreibers, der Stromquelle oder der Stromsenke elektrisch zu koppeln, und
die Abtasteinheit ferner eine Stromquelle, die konfiguriert ist, um die Pixel während der zweiten Testperiode mit einem zweiten Strom zu versorgen, aufweist, wobei die Abtasteinheit angepasst ist, um einen ersten Strom während der ersten Testperiode aufzunehmen und einen zweiten Strom während der zweiten Testperiode aufzunehmen, und um eine erste Spannung während der ersten Testperiode abzutasten und eine zweite Spannung während der zweiten Testperiode abzutasten, wobei der Datentreiber angepasst ist, um die externen Bilddaten gemäß der ersten und der zweiten Spannung umzuwandeln.

2. Organische lichtemittierende Anzeige nach Anspruch 1, wobei die Schalteinheit aufweist:
einen ersten Schalter, der zwischen die entsprechende der Datenleitungen und den Datentreiber geschaltet ist;
einen zweiten Schalter, der zwischen die entsprechende der Datenleitungen und die Stromquelle geschaltet ist;
einen dritten Schalter, der zwischen die entsprechende der Datenleitungen und die Stromsenke geschaltet ist; und
eine Schaltereinheit, die angepasst ist, um den ersten Schalter während der Betriebsperiode einzuschalten, den zweiten Schalter während der zweiten Testperiode einzuschalten und den dritten Schalter während der ersten Testperiode einzuschalten.

3. Organische lichtemittierende Anzeige nach einem der vorhergehenden Ansprüche, ferner aufweisend einen Speicher, der angepasst ist, um die erste Spannung und die zweite Spannung zu speichern.

4. Organische lichtemittierende Anzeige nach einem der vorhergehenden Ansprüche, ferner aufweisend eine Zeitsteuervorrichtung, die angepasst ist, um externe Datensignale zu empfangen, wobei die Zeitsteuervorrichtung konfiguriert ist, um die externen Datensignale gemäß der ersten Spannung und der zweiten Spannung in die Datensignale umzuwandeln.

5. Organische lichtemittierende Anzeige nach einem der vorhergehenden Ansprüche, wobei die erste Spannung eine Schwellenspannungs-/Mobilitätsinformation des Ansteuertransistors aufweist.

6. Organische lichtemittierende Anzeige nach einem der vorhergehenden Ansprüche, wobei die zweite Spannung eine Information über eine Verschlechterung der organischen lichtemittierenden Diode aufweist.

7. Organische lichtemittierende Anzeige nach einem der vorhergehenden Ansprüche, wobei die Abtasteinheit ferner einen Analog-Digital-Wandler, der angepasst ist, um die erste Spannung und die zweite Spannung in digitale Daten umzusetzen, aufweist.

8. Verfahren zur Einstellung der Leuchtdichte eines Bildes, das auf einer organischen lichtemittierenden Anzeige angezeigt wird, die aufweist:
einen Ansteuertreiber, der angepasst ist, um Ansteuersignale an eine Vielzahl von Ansteuerleitungen anzulegen und Steuersignale an eine Vielzahl von Steuerleitungen anzulegen;
einen Datentreiber, der angepasst ist, um während einer Betriebsperiode Datensignale eines Bildes an eine Vielzahl von Datenleitungen anzulegen, wobei die Datenleitungen die Ansteuerleitungen und die Steuerleitungen kreuzen;
eine Vielzahl von Pixeln, die angepasst sind, um das Bild anzuzeigen, und mit den Ansteuerleitungen, den Steuerleitungen und den Datenleitungen gekoppelt sind, wobei jeder der Pixel aufweist:
einen Ansteuertransistor und eine organische lichtemittierende Diode, die zwischen eine entsprechende der Energieversorgungsleitungen und eine Energiequelle in Reihe geschaltet ist, wobei die organische lichtemittierende Diode eine Anode, die mit dem Ansteuertransistor gekoppelt ist, und eine Kathode, die mit der zweiten Energiequelle gekoppelt ist, aufweist;
einen Datenschalter, der zwischen eine entsprechende der Datenleitungen und eine Steuerelektrode des Ansteuertransistors geschaltet ist, wobei der Datenschalter eine Steuerelektrode, die mit einer entsprechenden der Ansteuerleitungen gekoppelt ist, aufweist;
einen Kondensator, der zwischen eine entsprechende der Energieversorgungsleitungen und die Steuerelektrode des Ansteuertransistors geschaltet ist, und angepasst ist, um ein entsprechendes der Datensignale zu speichern; und
einen Steuerschalter, der zwischen die entsprechende der Datenleitungen und die Anode der organischen lichtemittierenden Diode geschaltet ist, wobei der Steuerschalter eine Steuerelektrode, die mit einer entsprechenden der Steuerleitungen gekoppelt ist, aufweist;
Energieversorgungstreiber, der mit einer Vielzahl von Energieversorgungsleitungen verbunden ist und angepasst ist, um die Pixel über die Energieversorgungsleitungen mit einer Versorgungsspannung zu versorgen;
eine Abtasteinheit, die eine Stromsenke, die konfiguriert ist, um während der ersten Testperiode einen ersten Strom von den Pixeln aufzunehmen, aufweist und angepasst ist, um während der ersten Testperiode eine erste Spannung abzutasten, und ferner angepasst ist, um während einer zweiten Testperiode eine zweite Spannung abzutasten, wobei der Datentreiber angepasst ist, um externe Bilddaten gemäß der ersten Spannung in ein an die Pixel anzulegendes Datensignal umzuwandeln, und ferner angepasst ist, um die externen Bilddaten gemäß der zweiten Spannung in das an die Pixel anzulegende Datensignal umzuwandeln; und
eine Schalteinheit, die angepasst ist, um die Vielzahl der Pixel selektiv mit der Stromsenke elektrisch zu koppeln,
**dadurch gekennzeichnet, dass**
die Versorgungsspannung aus einem Spannungsbereich zwischen einem ersten Pegel und einem zweiten Pegel ausgewählt werden kann, wobei der Energieversorgungstreiber ferner angepasst ist, um während der ersten Testperiode eine erste Versorgungsspannung, die einen höheren Pegel als eine zweite Versorgungsspannung, die während der zweiten Testperioden geliefert wird, aufweist, zu liefern,
die Schalteinheit ferner angepasst ist, um die Vielzahl der Pixel selektiv mit einem/r des Datentreibers, der Stromquelle oder der Stromsenke elektrisch zu koppeln, und
die Abtasteinheit ferner eine Stromquelle, die konfiguriert ist, um die Pixel während der zweiten Testperiode mit einem zweiten Strom zu versorgen, aufweist, wobei das Verfahren aufweist:
Abtasten einer ersten Spannung, während ein erster Strom über eine entsprechende der Datenleitungen durch den Ansteuertransistor eines Pixels aus der Vielzahl der Pixel zu einer Stromsenke fließt, während ein entsprechender der Pixel mit einer ersten Spannung versorgt wird;
Abtasten einer zweiten Spannung, während ein zweiter Strom von einer Stromquelle über die entsprechende der Datenleitungen durch die organische lichtemittierende Diode des Pixels fließt, während der entsprechende der Pixel mit einer zweiten Spannung, die niedriger als die erste Spannung ist, versorgt wird; und
Umwandeln externer Daten in ein an den Pixel anzulegendes Datensignal gemäß der ersten Spannung und der zweiten Spannung.

9. Verfahren nach Anspruch 8, ferner aufweisend Umsetzen der ersten Spannung und der zweiten Spannung in digitale Daten und Speichern der digitalen Daten in einem Speicher.

## Revendications

1. Dispositif d'affichage électroluminescent organique comprenant :
un pilote de balayage adapté pour appliquer des signaux de balayage à une pluralité de lignes de balayage et appliquer des signaux de commande à une pluralité de lignes de commande ;
un pilote de données adapté pour fournir des signaux de données d'une image à une pluralité de lignes de données au cours d'une période de fonctionnement, les lignes de données croisant les lignes de balayage et les lignes de commande ;
une pluralité de pixels adaptés pour afficher l'image et couplés aux lignes de balayage, aux lignes de commande et aux lignes de données, où chacun des pixels comprend :
un transistor d'attaque et une diode électroluminescente organique couplés en série entre une ligne correspondante parmi les lignes d'alimentation électrique et une source électrique, la diode électroluminescente organique ayant une anode couplée au transistor d'attaque et une cathode couplée à la deuxième source électrique ;
un commutateur de données connecté entre une ligne correspondante parmi les lignes de données et une électrode de commande du transistor d'attaque, le commutateur de données ayant une électrode de commande couplée à une ligne correspondante parmi les lignes de balayage ;
un condensateur couplé entre une ligne correspondante parmi les lignes d'alimentation électrique et l'électrode de commande du transistor d'attaque et adapté pour stocker un signal correspondant parmi les signaux de données ; et
un commutateur de commande connecté entre une ligne correspondante parmi les lignes de données et l'anode de la diode électroluminescente organique, le commutateur de commande ayant une électrode de commande couplée à une ligne correspondante parmi les lignes de commande ;
un pilote d'alimentation électrique connecté à une pluralité de lignes d'alimentation électrique et adapté pour fournir une tension d'alimentation électrique aux pixels par l'intermédiaire des lignes d'alimentation électrique ;
une unité de détection comprenant un puits de courant configurée pour absorber des courants circulant à travers le transistor d'attaque d'un pixel parmi la pluralité de pixels via une ligne correspondante parmi les lignes de données durant des périodes d'essai et adaptée pour détecter des tension durant des périodes d'essai, où le pilote de données est adapté pour régler une luminance d'une image en convertissant des données externes d'image en un signal de données devant être appliqué aux pixels en fonction des tensions ; et
une unité de commutation adaptée pour coupler électriquement de manière sélective la pluralité de pixels au puits de courant,
**caractérisé en ce que**
la tension d'alimentation électrique peut être sélectionnée à partir d'une plage de tensions comprise entre un premier niveau et un deuxième niveau, où le pilote d'alimentation électrique est en outre adapté pour fournir une première tension d'alimentation électrique au cours d'une première période parmi les périodes d'essai ayant un niveau supérieur à une deuxième tension d'alimentation électrique fournie au cours d'une deuxième période parmi les périodes d'essai,
l'unité de commutation est en outre adaptée pour coupler électriquement de manière sélective la pluralité de pixels à l'un (e) parmi le pilote de données, la source de courant ou le puits de courant, et
l'unité de détection comprend en outre une source de courant configurée pour fournir un deuxième courant aux pixels au cours de la deuxième période d'essai, où l'unité de détection est adaptée pour absorber un premier courant au cours de la première période d'essai et absorber un deuxième courant au cours de la deuxième période d'essai et détecter une première tension au cours de la première période d'essai et détecter une deuxième tension au cours de la deuxième période d'essai, où le pilote de données est adapté pour convertir les données externes d'image en fonction des première et deuxième tensions.

2. Dispositif d'affichage électroluminescent organique de la revendication 1, dans lequel l'unité de commutation comprend :
un premier commutateur connecté entre une ligne correspondante parmi les lignes de données et le pilote de données ;
un deuxième commutateur connecté entre une ligne correspondante parmi les lignes de données et la source de courant ;
un troisième commutateur connecté entre une ligne correspondante parmi les lignes de données et le puits de courant ; et
un dispositif de commande d'unité de commutation adapté pour activer le premier commutateur au cours de la période de fonctionnement, activer le deuxième commutateur au cours de la deuxième période d'essai, et activer le troisième commutateur au cours de la première période d'essai.

3. Dispositif d'affichage électroluminescent organique de l'une des revendications précédentes, comprenant en outre une mémoire adaptée pour stocker la première tension et la deuxième tension.

4. Dispositif d'affichage électroluminescent organique de l'une des revendications précédentes, comprenant en outre un dispositif de commande de synchronisation adapté pour recevoir des signaux de données externes, dans lequel le dispositif de commande de synchronisation est configuré pour convertir les signaux de données externes en signaux de données en fonction des première et deuxième tensions.

5. Dispositif d'affichage électroluminescent organique de l'une des revendications précédentes, dans lequel la première tension comprend des informations de tension/mobilité seuil du transistor d'attaque.

6. Dispositif d'affichage électroluminescent organique de l'une des revendications précédentes, dans lequel la deuxième tension comprend des informations de détérioration de la diode électroluminescente organique.

7. Dispositif d'affichage électroluminescent organique de l'une des revendications précédentes, dans lequel l'unité de détection comprend en outre un convertisseur analogique-numérique adapté pour convertir la première tension et la deuxième tension en données numériques.

8. Procédé de réglage de luminance d'une image affichée sur dispositif d'affichage électroluminescent organique comprenant :
un pilote de balayage adapté pour appliquer des signaux de balayage à une pluralité de lignes de balayage et appliquer des signaux de commande à une pluralité de lignes de commande ;
un pilote de données adapté pour fournir des signaux de données d'une image à une pluralité de lignes de données au cours d'une période de fonctionnement, les lignes de données croisant les lignes de balayage et les lignes de commande ;
une pluralité de pixels adaptés pour afficher l'image et couplés aux lignes de balayage, aux lignes de commande et aux lignes de données, où chacun des pixels comprend :
un transistor d'attaque et une diode électroluminescente organique couplés en série entre une ligne correspondante parmi les lignes d'alimentation électrique et une source électrique, la diode électroluminescente organique ayant une anode couplée au transistor d'attaque et une cathode couplée à la deuxième source électrique ;
un commutateur de données connecté entre une ligne correspondante parmi les lignes de données et une électrode de commande du transistor d'attaque, le commutateur de données ayant une électrode de commande couplée à une ligne correspondante parmi les lignes de balayage ;
un condensateur couplé entre une ligne correspondante parmi les lignes d'alimentation électrique et l'électrode de commande du transistor d'attaque et adapté pour stocker un signal correspondant parmi les signaux de données ; et
un commutateur de commande connecté entre une ligne correspondante parmi les lignes de données et l'anode de la diode électroluminescente organique, le commutateur de commande ayant une électrode de commande couplée à une ligne correspondante parmi les lignes de commande ;
un pilote d'alimentation électrique connecté à une pluralité de lignes d'alimentation électrique et adapté pour fournir une tension d'alimentation électrique aux pixels par l'intermédiaire des lignes d'alimentation électrique ;
une unité de détection comprenant un puits de courant configurée pour absorber un premier courant à partir des pixels au cours d'une première période d'essai et adaptée pour détecter une première tension au cours de la première période d'essai et adaptée en outre pour détecter une deuxième tension au cours d'une deuxième période d'essai, où le pilote de données est adapté pour convertir des données externes d'image en un signal de données devant être appliqué aux pixels en fonction de la première tension et adapté en outre pour convertir les données externes d'image en un signal de données devant être appliqué aux pixels en fonction de la deuxième tension ; et
une unité de commutation adaptée pour coupler électriquement de manière sélective la pluralité de pixels au puits de courant,
**caractérisé en ce que**
la tension d'alimentation électrique peut être sélectionnée à partir d'une plage de tensions comprise entre un premier niveau et un deuxième niveau, où le pilote d'alimentation électrique est en outre adapté pour fournir une première tension d'alimentation électrique au cours de la première période d'essai ayant un niveau supérieur à une deuxième tension d'alimentation électrique fournie au cours de la deuxième période d'essai,
l'unité de commutation est en outre adaptée pour coupler électriquement de manière sélective la pluralité de pixels à l'un(e) parmi le pilote de données, la source de courant ou le puits de courant, et
l'unité de détection comprend en outre une source de courant configurée pour fournir un deuxième courant aux pixels au cours de la deuxième période d'essai, le procédé comprenant le fait :
de détecter une première tension lorsqu'un premier courant circule à travers le transistor d'attaque d'un pixel parmi la pluralité de pixels vers un puits de courant via une ligne correspondante parmi les lignes de données lorsqu'une première tension est fournie à un pixel correspondant parmi les pixels ;
de détecter une deuxième tension lorsqu'un deuxième courant circule à partir d'une source de courant à travers la diode électroluminescente organique du pixel via la ligne correspondante parmi les lignes de données lorsqu'une deuxième tension qui est inférieure à la première tension est fournie au pixel correspondant parmi les pixels ; et
de convertir des données externes en un signal de données devant être appliqué au pixel en fonction de la première tension et de la deuxième tension.

9. Procédé selon la revendication 8, comprenant en outre le fait de convertir la première tension et la deuxième tension en données numériques et de stocker les données numériques dans une mémoire.
